# EUROPÄISCHE PATENTSCHRIFT

(11) **EP 2 162 563 B1**
(45) Veröffentlichungstag und Bekanntmachung des Hinweises auf die Patenterteilung: **15.08.2012**
(21) Anmeldenummer: 08758116.1
(22) Anmeldetag: 23.05.2008
(51) Int. Cl.: C03C 17/36, C03C 17/34, C23C 14/08, C23C 14/58, H01L 31/18, C23C 26/00, C23C 28/00, C23C 30/00

(54) **TEMPERATURSTABILE TCO-SCHICHT UND VERFAHREN ZUR HERSTELLUNG**
TEMPERATURE-RESISTANT TCO LAYER AND PRODUCTION METHOD THEREFOR
COUCHE DE TCO RÉSISTANT À LA TEMPÉRATURE ET SON PROCÉDÉ DE RÉALISATION

(30) Priorität: 28.05.2007 DE 102007024986
(43) Veröffentlichungstag der Anmeldung: 17.03.2010
(73) Patentinhaber: Helmholtz-Zentrum Berlin für Materialien und Energie GmbH, 14109 Berlin (DE); Forschungszentrum Jülich GmbH, 52425 Jülich (DE)
(72) Erfinder: LEE, Kyo Youl, 33649 Bielefeld (DE); BERGHOLD, Juliane, 13083 Berlin (DE); BERGINSKI, Michael, 85640 Putzbrunn (DE); GALL, Stefan, 13597 Berlin (DE); HÜPKES, Jürgen, 47877 Willich (DE); MUSKE, Martin, 12437 Berlin (DE); RECH, Bernd, 12587 Berlin (DE)
(86) Internationale Anmeldenummer: PCT/DE2008/000876
(87) Internationale Veröffentlichungsnummer: WO 2008/145099

(56) Entgegenhaltungen:
- WO-A-2007/092120
- US-A1- 2007 029 186
- D. DIMOVA-MALINOVSKA, O. ANGELOV, M. KAMENOVA, A. VASEASHTA, J.C. PIVIN: "Structural properties of poly-Si thin films grown on ZnO : Al coated glass substrates by aluminium induced crystallisation" JOURNAL OF OPTOELECTRONICS AND ADVANCED MATERIALS, Bd. 9, Nr. 2, Februar 2007 (2007-02), Seiten 355-388, XP008096916
- LEE K Y ET AL: "Temperature stability of ZnO:Al film properties for poly-Si thin-film devices" APPLIED PHYSICS LETTERS AMERICAN INSTITUTE OF PHYSICS USA, Bd. 91, Nr. 24, 10. Dezember 2007 (2007-12-10), Seiten 241911-1, XP002497653 ISSN: 0003-6951

## Beschreibung

### BESCHREIBUNG

Die Erfindung bezieht sich auf eine transparente und leitfähige Oxidschicht aus Aluminium-dotiertem Zinkoxid auf einem Substrat und auf ein Verfahren zur Herstellung.

Transparente leitfähige Oxide (TCO - Transparent Conductive Oxide) werden z.B. im Bereich der Dünnschichtphotovoltaik zur Kontaktbildung eingesetzt. TCOs sollen dabei eine möglichst hohe optische Transparenz und eine möglichst hohe elektrische Leitfähigkeit aufweisen. Zu den TCOs gehört u.a. das Zinkoxid ZnO, dotiert mit Aluminium Al oder Gallium Ga. Üblicherweise wird ZnO:Al bei relativ geringen Temperaturen z.B. durch Sputtern auf einen Träger, in der Regel auf einem Glassubstrat, hergestellt. Durch nachträgliche Temperaturbehandlungen oberhalb der Herstellungstemperatur (beispielsweise für die weitere Prozessierung zu einer Solarzelle) verändern sich dann jedoch die optischen und elektrischen Eigenschaften der ZnO:Al-Schicht, insbesondere wird die elektrische Leitfähigkeit verringert. Die Veränderungen der Eigenschaften limitieren den Einsatz der ZnO:Al-Schichten. Bisher waren die Anwendungen derartiger ZnO:Al-Schichten als TCO deshalb auf relativ geringe Temperaturen bei den nachfolgenden Prozessschritten limitiert, da die ansonsten auftretenden Veränderungen der Eigenschaften nicht akzeptabel waren. Bei Anwendungen mit höheren Temperaturanforderungen konnten die ZnO:Al-Schichten also nicht verwendet werden.

### STAND DER TECHNIK

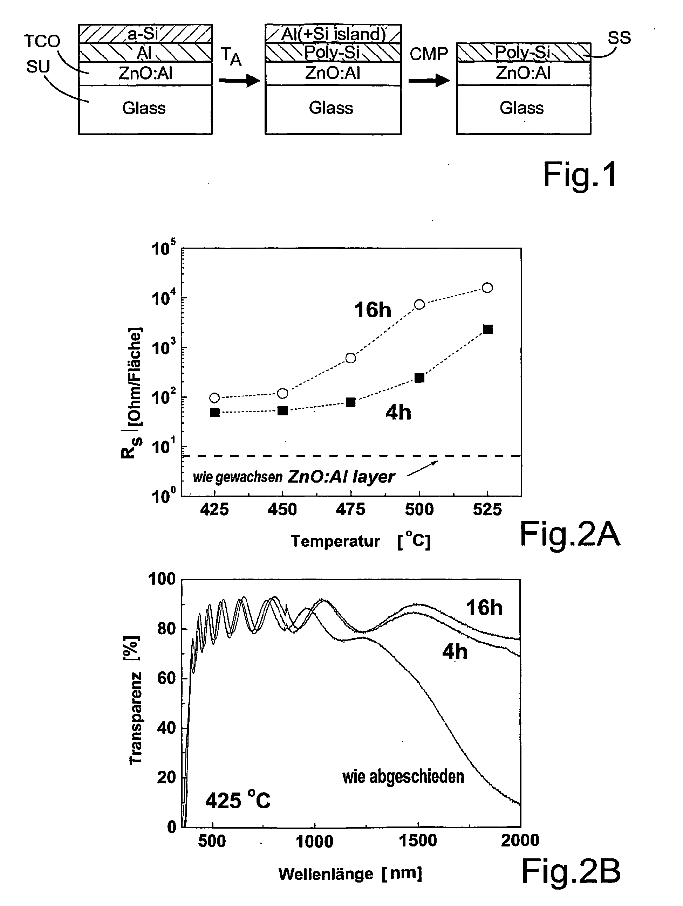

In der **VERÖFFENTLICHUNG I** von M.Berginski et al.: "ZnO Films with tailored material properties for highly efficient thin-film silicon solar modules" (Proc.21 st EPVSEC, Dresden, Germany (2006) pp 1539-1545) wird in der Figur 2 gezeigt, dass sich die elektrischen Eigenschaften einer ZnO:Al-Schicht durch eine Temperaturbehandlung oberhalb der Herstellungstemperatur verschlechtern.

Aus dem Stand der Technik sind verschiedene Maßnahmen zur Temperaturstabilisierung von TCO-Schichten bekannt. Beispielsweise lehrt die US 2006/0137738 A1 einen Aufbau der TCO-Schicht unter Beteiligung eines fünfwertigen Elements und die EP 1 465 262 A2 eine Behandlung einer ZnO-Schicht mit einer sauerstoffhaltigen Inertgasatmosphäre bei einer Temperatur unterhalb von 400°C. Temperaturstabile Kontakte sind beispielsweise aus der DE 103 34 353 A1 bekannt. Hier wird ein passivierter Kontakt zwischen einer ersten Schicht aus Silizid, Germanid oder einem Metall und einer angrenzenden Halbleiterfläche durch Passivierung der Grenzfläche ausgebildet.

Verfahren zur Herstellung einer TCO-Schicht aus dotiertem Zinkoxid sind beispielsweise aus der DE 10 2004 003 760 A1**,** der DE 42 07 783 C2 und der DE 36 39 508 A1 bekannt. Die Verwendung einer TCO-Schicht aus dotiertem Zinkoxid in Solarzellen ist ebenfalls aus der DE 10 2004 003 760 A1 bekannt. Grundsätzlich erfolgt der Einsatz von TCO-Schichten im Stand der Technik bislang aber nur in Solarzellen, die bei einer Temperatur unterhalb einer Temperatur T_{P}, bei der die TCO-Schicht Veränderungen ihrer optischen und elektrischen Eigenschaften zeigt, prozessiert werden.

Der Einsatz von n-ZnO:Al als Fensterschicht in Solarzellen ist beispielsweise aus der **VERÖFFENTLICHUNG II** von S. Visbeck "Einsatz von n-ZnO:Al als

Fensterschicht in der Pilotfertigung von CIGSSe-Solarmodulen: Status & Entwicklung" (FVS Workshop 2005, Session III, pp 66-70) bekannt.

Weiterhin ist aus der DE 101 41 090 A1 bekannt, auf einem Glassubstrat eine transparente Elektrode aus Zinnoxid (SnO₂) vorzusehen, auf der sich eine amorphe Siliziumschicht befindet. Mit dieser wird eine Nickelschicht als Metallkatalysatorelement in Kontakt gebracht, sodass die amorphe Siliziumschicht nach einer Wärmebehandlung bei 550°C in eine kristallographisch hochorientierte, polykristalline Siliziumschicht vom n-Typ überführt wird. Diese Schicht wird dann als Keimkristall genutzt, um weiteres polykristallines Silizium darauf aufzuziehen (vergleiche Figur 6). Die Zielrichtung der DE 101 41 090 A1 ist das Vorsehen einer Keimschicht mit guten kristallinen Eigenschaften. Ein Wärmeschutz der Zinnoxidschicht bei der Wärmebehandlung bei 550°C ist nicht vorgesehen und auch nicht notwendig, da die in DE 101 41 090 A1 verwendeten Zinnoxidschichten typischerweise bei 500°C - 600°C durch APCVD-Verfahren hergestellt werden. Die Aufgabe der Keimschicht ist die Ausbildung einer möglichst guten Kristallinität für die nachfolgende pin- Solarzellenstruktur, die bei 200°C - 300°C hergestellt wird.

Aus der **VERÖFFENTLICHUNG III** von T.Nakada et al.: "Novel device structure for Cu(In,Ga)Se2 thin film solar cells using transparent conducting oxide back and front contacts" (Solar Energy 77 (2004) pp 739-747) wird beschrieben, dass die TCO-Schicht allerdings in einem Prozessschritt so stark aufgeheizt wird, sodass sich die optischen und elektrischen Eigenschaften der TCO-Schicht merklich verschlechtern. Dies ist erkennbar an dem maximal erreichten Wirkungsgrad von 12 %, der deutlich unterhalb dem für CIS-Solarzellen in der Substrat-Konfiguration erreichbaren maximalen Wirkungsgrad von 19% liegt.

Aus der US 2007/0029186 A1 ist es bekannt, eine transparente und leitfähige anorganische Schutzschicht aus Siliziumnitrid auf ein TCO-beschichtetes Glassubstrat (ZnO als TCO) aufzubringen, bevor dieses gehärtet/vorgespannt wird ("thermally tempering"). Bei der Glashärtung/Vorspannung handelt es sich um einen allgemein bekannten Hochtemperaturprozess bei Temperaturen von mindestens 580°C und höher (600/620/640°C) über einen relativ kurzen Zeitraum im Minutenbereich. Es wird festgestellt, dass sich bei der Glashärtung die elektrische Leitfähigkeit der TCO-Schicht signifikant verringert. Daher wird eine anorganische Schutzschicht auf der trägerabgewandten Seite der TCO-Schicht vorgesehen, die die Oxidation der TCO-Schicht während der Aushärtung verringert, sodass die Verringerung der elektrischen Leitfähigkeit weniger signifikant ausfällt. Zweck der bekannten Schutzschicht ist somit der Luftabschluss der TCO-Schicht bei der Glashärtung. Das Aufbringen der TCO-Schicht auf das Glassubstrat erfolgt durch Sputtern bei Raumtemperatur. Die Schutzschicht wird ebenfalls durch Sputterdeposition aufgebracht, eine Temperaturangabe erfolgt hierfür jedoch nicht.

Der der Erfindung nächstliegende Stand der Technik wird in der VERÖFFENTLICHUNG von D. Dimova-Malinovska et al. "Structural properties of poly-Si thin films grown on ZnO:Al coated glass substrates by aluminium induced crystallisation" (Journal of Optoelectronics and Advanced materials, Bd.9, Nr.2, Februar 2007, Seiten 355-358) beschrieben. Es wird eine ZnO:Al TCO-Schicht offenbart, auf der eine polykristalline Silizium-Schicht durch Erhitzung bei 480-530°C erzeugbar ist. Dabei wird die ZnO:Al TCO-Schicht durch RF-Magnetronsputtern mit einem ZnO:Al₂O₃-Target mit 2 Gew% Al₂O₃ bei einer Substrattemperatur von 200°C abgeschieden. Bei einem so hohen Aluminiumgehalt und einer so niedrigen Substrattemperatur bildet sich aber keine Schutzschicht mit einer ausreichenden Schutzwirkung auf der TCO-Schicht auf der substratabgewandten Seite aus, die deren gute optische und elektrische Eigenschaften bei einer anschließenden Prozessierung bei höheren Temperaturen sicher schützen kann. Die Mobilität der Ladungsträger, die die elektrische Leitfähigkeit mitbeeinflusst, wird durch die hohe Anzahl von Ladungsträgern wesentlich eingeschränkt. Eine hohe Anzahl von Ladungsträgern verringert daneben auch die Transparenz der TCO-Schicht. Auf eine Schutzschicht mit einer optischen und elektrischen Schutzwirkung wird in der Veröffentlichung dann auch nicht eingegangen, es wird ausschließlich über die strukturellen Eigenschaften der aluminiuminduziert erzeugten polykristallinen Silizium-Schicht berichtet.

### AUFGABENSTELLUNG

Die **AUFGABE** für die vorliegende Erfindung ist daher darin zu sehen, eine TCO-Schicht aus Aluminium-dotiertem Zinkoxid so weiterzubilden, dass diese bei einer Anwendung in Anordnungen mit einer Prozessierung bei Temperaturen oberhalb einer Temperatur T_{P}, bei der die TCO-Schicht keine Beeinträchtigungen ihrer optischen und vornehmlich elektrischen Eigenschaften zeigt. Weiterhin soll ein Herstellungsverfahren angegeben werden, das einfach, kostengünstig und effizient durchführbar ist. Die LÖSUNG für diese Aufgaben sind den nebengeordneten Ansprüchen zu entnehmen. Vorteilhafte Weiterbildungen werden in den Unteransprüchen aufgezeigt und im Folgenden im Zusammenhang mit der Erfindung näher erläutert.

Die erfindungsgemäße temperaturstabile ZnO:Al-Schicht auf einem Substrat ist in einer Dicke von 690 nm herstellbar durch nicht-reaktives RF-Sputtern mit einem ZnO:Al₂O₃-Target mit 1 Gew% Al₂O₃ bei einem Druck von 0,1 Pa während der Deposition und einer Substrattemperatur von 300°C und weist eine transparente und leitfähig anorganische Schutzschicht aus Silizium auf ihrer für die Prozessierung vorgesehenen, substratabgewandten Oberfläche auf, die durch anschließendes Erhitzen bei einer Temperatur T_{A} zwischen 425°C und 525°C herstellbar ist, wobei bei einer bis 500°C erzeugten Schutzschicht der spezifische Widerstand der ZnO:Al-Schicht konstant bei 3·10⁻⁴ Ω·cm und bei einer ab 500°C erzeugten Schutzschicht unterhalb von 3·10⁻⁴ Ω·cm liegt. Dabei kann die Schutzschicht eine polykristalline Ausbildung zeigen. Eine amorphe und mikrokristalline Ausbildung ist aber ebenfalls möglich.

Durch das Vorsehen einer Schutzschicht auf der Prozessierungsseite der ZnO:Al-Schicht wird eine ansonsten bei höheren Prozesstemperaturen dort auftretende Verdampfung von Zn-Atomen aus der Oberfläche der ZnO:Al-Schicht effizient verhindert. Dadurch tritt bei der Erfindung auch bei hohen Prozesstemperaturen oberhalb der Herstellungstemperatur der ZnO:Al-Schicht keine Verschlechterung insbesondere der elektrischen Eigenschaften der ZnO:Al-Schicht auf. Durch die Leitfähigkeit und Transparenz der erfindungsgemäß vorgesehenen Schutzschicht selbst werden die optischen und elektrischen Eigenschaften der ZnO:Al-Schicht ebenfalls nicht verschlechtert, sodass das Vorsehen einer zusätzlichen Schutzschicht auch keine Nachteile erbringt. Eine Verbesserung der optischen und elektrischen Eigenschaften durch die Temperaturbehandlung ist im Falle der geschützten ZnO:Al-Schicht möglich und wurde bereits beobachtet (siehe unter Ausführungsbeispiele).

Insbesondere wird durch das Vorsehen der Schutzschicht bei der erfindungsgemäßen ZnO:Al-Schicht deren nachfolgende Prozessierung oberhalb von 450°C, insbesondere oberhalb von 500°C, 550°C und sogar 600°C ermöglicht. Durch die bei einer niedrigeren Temperatur T_{A}, zwischen 425°C und 525°C, insbesondere wegen der erzeugbaren Korngrößen zwischen 425°C und 450°C, erzeugte Schutzschicht bleiben die Eigenschaften der TCO-Schicht auch bei Temperaturbehandlungen oberhalb ihrer Erzeugungstemperatur erhalten. Weiter unten wird noch aufgezeigt, dass sich diese sogar noch verbessern. Eine Reduzierung der elektrischen Leitfähigkeit der ZnO:Al-Schicht tritt nicht mehr auf. Die vorliegende Erfindung ermöglicht daher durch das Vorsehen der speziellen, die ZnO:Al-Schicht in ihrem Temperaturverhalten stabilisierenden Schutzschicht Verwendungen von ZnO:Al-Schicht in Schichtstrukturen bzw. Bauelementen, die durch die bislang bestehende Temperaturlimitierung zur Vermeidung der Verschlechterung von optischen und elektrischen Eigenschaften der TCO-Schicht nicht möglich waren. Nunmehr wird auch ein Einsatz der mit der Temperaturstabilisierungsschicht geschützten ZnO:Al-Schicht bei höheren Temperaturen ermöglicht und damit der Anwendungsbereich, insbesondere auch im Bereich der Solarzellenanwendungen und der beschichteten technischen Gläser, wesentlich erweitert.

Beispielsweise können mit der temperaturstabilen ZnO:Al-Schicht nach der Erfindung CIS-Solarzellen (Kuper-Indium-Sulfid) gemäß VERÖFFENTLICHUNG III, Abschnitt 3, Figur 1 mit einer Prozessierung der Solarzellen auf einem mit ZnO beschichteten Glassubstrat hergestellt werden. Die dort aufgezeigte Verringerung des Wirkungsgrades durch eine Verschlechterung der Eigenschaften der TCO-Schicht aufgrund von Wärmeeinwirkung oberhalb der Erzeugungstemperatur von ZnO tritt bei einem Einsatz der temperaturstabilen ZnO:Al-Schicht nach der Erfindung nicht mehr auf. Für hocheffiziente CIS-Solarzellen werden beispielsweise Prozesstemperaturen oberhalb von 500°C angewandt, ebenso für CdTe-Solarzellen. Für letztere wird ITO oder SnO₂ als TCO verwendet. Letzteres wird - wie bereits beschrieben - jedoch typischerweise bei Temperaturen um 550°C hergestellt. Die Erfindung ermöglicht hier jetzt den Einsatz von ZnO:Al-Schichten, die mit kostengünstigen Verfahren bei vergleichsweise niedrigen Prozesstemperaturen (unter 400°C) hergestellt werden, wobei diese so geschützt werden, dass nunmehr Prozesstemperaturen oberhalb 450°C möglich werden, ohne die elektrischen Eigenschaften der ZnO:Al-Schichten und deren Funktionsweise in Bauelementen zu schädigen.

Weiterhin können auch polykristalline Si-Solarzellen auf der temperaturstabilen ZnO:Al-Schicht nach der Erfindung aufgewachsen werden, wobei hierbei die Schutzschicht gleichzeitig auch als polykristalline Keimschicht für die aufzuwachsenden Si-Dünnschichten dienen kann. Die nachfolgende, siliziumhaltige Absorberschicht wird dabei bei Prozesstemperaturen oberhalb von 450°C entweder direkt gewachsen oder erst als amorphe Schicht hergestellt und anschließend bei Prozesstemperaturen oberhalb von 450°C kristallisiert. Auch äquivalente Verfahren zur Rekristallisation, die beispielsweise auf Laserlicht- oder Elektronenstrahl-unterstützter Kristallisation beruhen, arbeiten bei derartig hohen Prozesstemperaturen (die lokal durch Aufschmelzen mit dem Laser- oder Elektronenstrahl erreicht werden) und erfordern deshalb analog den thermischen Schutz der ZnO:Al-Schicht durch die Schutzschicht nach der Erfindung.

Weiter unten wird noch aufgezeigt, dass die Schutzschicht polykristallin ausgebildet sein kann und damit eine für eine nachfolgende Prozessierung ausreichende Korngröße und eine bevorzugte Ausrichtung der Kristallite aufweist und sich deshalb besonders als Keimschicht eignet. Bei Si-Dünnschichten wird vor der Weiterprozessierung der auf der Keimschicht aufgewachsene amorphe siliziumhaltige Schichtstapel entweder in einem Hochtemperaturschritt, der zur Rekristallisation der amorphen Siliziumschichten führt, oder mit einem Laser (Laserkristallisation) behandelt. In beiden Fällen leidet die temperaturstabile ZnO:Al-Schicht nach der Erfindung nicht und gewährt optimale optische und elektrische Eigenschaften und damit hohe Wirkungsgrade der prozessierten Solarzelle. Die mögliche Verwendung von temperaturstabilen ZnO:Al-Schichten in Dünnschichtsolarzellen ermöglicht dann wesentlich einfachere Schaltungskonzepte als aus dem Stand der Technik bekannt.

Beispielsweise kann eine Anwendung der Erfindung in dem in der **VERÖFFENTLICHUNG IV** von P. Basore: "Expanding the Production of a New Polycrystalline Silicon PV Technology" (Proc. 21 st EPVSEC, Dresden, Germany (2006), pp 544-548) vorgestellten Konzepten oder in dem in der **VERÖFFENTLICHUNG V** von S. Gall et al.: "Large-grained Polycristalline Silicon on Glass for Thin-Film Solar Cells" (Proc. 21 st EPVSEC, Dresden, Germany (2006), pp 1091-1094) erhebliche Vorteile bringen.

Weiterhin können mit der Erfindung temperaturstabile hochleitfähige ZnO:Al-Schichten für verschiedene Anwendungen zur Verfügung gestellt werden. Qualitativ hochwertige ZnO:Al-Schichten werden in der Regel bei höheren oder hohen Substrattemperaturen in Vakuumbeschichtungsanlagen hergestellt (z.B. Magnetronsputtern). Unter Anwendung der Erfindung können die ZnO:Al-Schichten bei niedrigen Temperaturen, beispielsweise kalt gesputtert und dann anschließend in einer offenen Anlage ohne Vakuum zur Erreichung der gewünschten optischen und elektrischen Eigenschaften thermisch nachbehandelt werden. Dabei kann es für die Verwendung der erzeugten Produkte (beispielsweise technische Aluminium-dotierte ZnO-beschichtete Gläser) vorteilhaft sein, wenn nach der thermischen Nachbehandlung die Schutzschicht wieder entfernt wird.

Die folgenden Ausführungen beziehen sich auf mit Aluminium-dotiertes ZnO (ZnO:Al), können aber analog auf eine Dotierung mit Gallium übertragen werden, da Gallium in derselben Hauptgruppe wie Aluminium zu finden und als chemisch äquivalent anzusehen ist. Weiterhin kann die temperaturstabile ZnO:Al-Schicht nach der Erfindung auch auf ein Substrat, bevorzugt aus Glas, aufgebracht sein, bei dem sich die TCO-Schicht unterhalb bezüglich der Funktionseinwirkung, beispielsweise Lichteinfall, befindet (Superstrat). Auch hier sind beide Ausführungsformen als äquivalent anzusehen und grundsätzlich analog in die Ausführungen miteinzubeziehen.

Die temperaturstabile ZnO/AL-Schicht weist nach der Erfindung eine Schichtdicke von 690 nm und die Schutzschicht weist bevorzugt eine Schichtdicke in einem Bereich von 100 nm auf, sodass sich eine gesamte Schichtdicke der temperaturstabilen ZnO:Al-Schicht nach der Erfindung in einem Bereich von 800 nm ergibt. Dabei ist die Schichtdicke der Schutzschicht von der spezifischen Anwendung abhängig. In poly-Si Dünnschichtsolarzellen kann beispielsweise die vollständige Siliziumdünnschichtsolarzelle auf der ZnO:Al-Schicht abgeschieden werden und dann komplett bei hohen Prozesstemperaturen (oberhalb 450°C) kristallisiert werden. Hier dient das ganze Siliziumschichtpaket mit einer typischen Dicke von 1-5 µm als Schutzschicht, die sich bildet, wenn die Prozesstemperatur noch unterhalb derjenigen Temperatur liegt, bei der ungeschütztes ZnO Veränderungen seiner optischen und elektrischen Eigenschaften zeigen würde. In der Anwendung als hochdotierte kristallisierte Saatschicht ist die Dicke der Schutzschicht möglichst dünn zu wählen (typischerweise 10-20 nm). Bei einer Herstellung der temperaturstabilen ZnO:Al-Schicht nach dem ALILE Verfahren (s.u.) ist eine Schichtdicke von 100-200 nm für die Schutzschicht vorteilhaft, um möglichst große Kristallite zu realisieren.

Das temperaturstabilisierte Schichtsystem nach der Erfindung kann mit verschiedenen Verfahren, beispielsweise mittels Sputtern, Epitaxie oder CVD, hergestellt werden. Bevorzugt wird ein Verfahren zur Herstellung einer transparenten und leitfähigen Oxidschicht aus Aluminium-dotiertem Zinkoxid in einer Dicke von 690 nm auf einem Substrat mit einer transparenten und leitfähigen, anorganischen Schutzschicht aus Silizium auf der substratabgewandten Oberfläche durch nicht-reaktives RF-Sputtern mit einem ZnO:Al₂O₃-Target mit 1 Gew% Al₂O₃ bei einem Druck von 0,1 Pa während der Deposition und einer Substrattemperatur von 300°C und anschließendes Erhitzen bei einer Temperatur T_{A} zwischen 425°C und 525°C eingesetzt.

Dabei kann das Verfahren auf dem bekannten ALILE-Prozess (Aluminum-Induced Layer Exchange) basieren. Dieser stellt eine spezielle Form der aluminium-induzierten Kristallisation (AIC Aluminium-Induced Crystallization) dar, bei der eine Schichtfolge Substrat/Al/A-Si in eine Schichtenfolge Substrat/poly-Si/Al(+Si-Inseln) durch einen einfachen Temperschritt (engl. Annealing) bei einer Temperatur unterhalb der eutektischen Temperatur des Systems Al/Si (577°C) dar. Üblicherweise wird der ALILE-Prozess zur direkten Erzeugung von Keimschichten auf einem Glassubstrat für eine nachfolgende Prozessierung von polykristallinen Dünnschicht-Solarzellen eingesetzt (vergleiche beispielsweise **VERÖFFENTLICHUNG VI** von K. Lips et al.: "Kristallines Silicium auf Glas: Herstellung und Materialeigenschaften", Forschungsverbund Sonnenenergie FVS, Themen 2000, pp109-115).

Im Zusammenhang mit der Erfindung stellt es eine attraktive Option für poly-Si-Dünnfilm-Solarzellen dar, eine Keimschicht auf einem TCO-beschichteten Substrat aufzubauen, da das TCO eine hohe Transparenz im Spektralbereich der Solarzelle und eine hohe elektrische Leitfähigkeit zeigt. TCO-Schichten werden jedoch bislang nur bei der Herstellung von Dünnschicht-Solarzellen, basierend auf amorphem Silizium (a:Si) oder mikrokristallinem Silizium (µc:Si), eingesetzt. Ein Einsatz in Dünnschicht-Solarzellen, basierend auf poly-Si, findet bislang nicht statt, da sich bei der erforderlichen Temperaturbehandlung des polykristallinen Siliziums die optischen und elektrischen Eigenschaften der TCO-Schicht signifikant verschlechtern.

Modifikationen des Herstellungsverfahrens auf Basis des ALILE-Prozesses können folgende Verfahrensschritte umfassen:
- Aufbringen der Aluminiumschicht und der amorphen Siliziumschicht auf die TCO-Schicht aus dotiertem Zinkoxid mittels DC-Sputtern.
- natürliches Oxidieren der Aluminiumschicht an Luft über einen Zeitraum von 2 Stunden.
- Abtragen der Aluminiumschicht mit Silizium-Inseln bis auf die Schutzschicht mittels chemisch-mechanischem Polieren.
- Aufbringen der Aluminiumschicht auf die TCO-Schicht aus dotiertem Zinkoxid in einer Schichtdicke in einem Bereich von 300 nm und/oder
- Aufbringen der amorphen Siliziumschicht in einer Schichtdicke in einem Bereich von 375 nm.

### AUSFÜHRUNGSBEISPIELE

Ausbildungsformen der temperaturstabilen ZnO:Al-Schicht nach der Erfindung und zu Verfahren zu seiner Herstellung werden nachfolgend zum weiteren Verständnis der Erfindung anhand der schematischen Figuren näher erläutert. Dabei zeigt:
- **FIGUR 1**: den Aufbau der temperaturstabilen ZnO:Al-Schicht unter Einbeziehung des ALILE-Prozesses,
- **FIGUR 2A**: ein Diagramm zum Schichtwiderstand R_{S} der Schutzschicht in Abhängigkeit von der Temperatur T_{A},
- **FIGUR 2B**: ein Diagram zur optischen Transparenz der Schutzschicht in Abhängigkeit von der Wellenlänge,
- **FIGUR 3**: ein Diagramm zur Abhängigkeit von Temperatur T_{A} und spezifischem Widerstand mit dem Parameter verschiedener Schichtaufbauten und
- **FIGUREN 4A BIS C**: verschiedene Diagramme zur Kristallqualität der Schutzschicht.

### BESCHREIBUNG DER DURCHGEFÜHRTEN EXPERIMENTE

In Zusammenarbeit mit dem FZ Jülich wurden Experimente zur Herstellung von grobkörnigen polykristallinen Silizium-Schichten auf ZnO:Al-beschichteten Glassubstraten SU durchgeführt. Dafür wurde eine Struktur Glassubstrat/ ZnO:Al/ Al/a-Si hergestellt. Mittels Sputtern (RF) wurde eine ZnO:Al-Schicht (ca. 700 nm) auf das Glassubstrat (Borofloat 33 von Schott) deponiert. Anschließend erfolgte die Abscheidung einer Aluminium-Schicht (ca. 300 nm) und einer amorphen Silizium-Schicht (ca. 375 nm) mittels Sputtern (DC). Vor der Abscheidung der a-Si-Schicht erfolgte eine zweistündige natürliche Oxidation der Al-Schicht in Luftatmosphäre. Durch eine Temperaturbehandlung im Ofen (bei einer Temperatur T_{A} = 425°C ... 525°C) ergab sich eine Schichtstruktur mit dem Aufbau Giassubstrat/ZnO:Al/poly-Si/Al(+Si). Durch den ALILE-Prozess wurde der AI/a-Si- in einen poly-Si/Al(+Si-Island)-Stapel umgewandelt. Anschließend wurde die obere Al(+Si-Island)-Schicht mittels CMP (Chemical Mechanical Polishing) abgetragen. Zurück bleibt die Schutzschicht SS nach der Erfindung in polykristalliner, siliziumhaltiger Ausführungsform (vergleiche **FIGUR 1****).**

Der ALILE-Prozess erfordert eine dünne, permeable Membran ME (vergleiche FIGUR 1) zwischen der initialisierenden Al-Schicht und der amorphen Siliziumschicht zur Kontrolle der Diffusion von A und Si. Diese Membran ME bleibt während der Durchführung des gesamten ALILE-Prozesses erhalten und kann gebildet werden durch eine natürliche Oxidation der Al-Schicht in Luft für 2 h, bevor die a-Si-Schicht aufgebracht wird.

### EXPERIMENTELLE DETAILS ZUM ALILE-PROZESS

### ZNO:AL-SCHICHT

- nicht-reaktives RF-Sputter-System
- Dicke: 690 nm
- Target: ZnO:Al₂O₃ Target mit 1 Gew% Al₂O₃
- Druck während der Deposition: 0,1 Pa
- Substrattemperatur: 300°C

### AL- UND A-SI-SCHICHT

- DC-Magnetron-Sputter-System zur Erzeugung der:
- Druck während der Deposition: 6,5x10⁻³ mbar
- Dicke: 300 nm (Al-schicht), 375 nm (a-Si-Schicht)
- Membranbildung (Aluminiumoxid): Luft für 2 h

### SUBSTRAT-PRÄPARATION

- Glassäuberung mit Mucasol-Lösung
- ZnO:Al-Säuberung mit heißem Wasser
- ALILE-Prozess (Herstellungstemperatur T_{A} 425°C bis 525°C, Temperzeit: 16 h bei 425°C bis 450°C und 4 h bei 475°C bis 525°C.
- CMP-Prozess zur Entfernung der Topschicht (Al mit Si-Inseln)

### CHARAKTERISIERUNG

- EBSD für die Größe und Orientierung der entstandenen Körner
- Ramanspektrum für die Kristallqualität.

In einem anderen Herstellungsverfahren wurde auf die ZnO-beschichteten Glassubstrate (hergestellt wie oben) eine dünne amorphe Siliziumschicht mit Elektronenstrahlverdampfen aufgebracht. Das Schichtpaket wurde dann bei 600°C für eine Stunde thermisch behandelt (Ausheizen im Vakuum) und elektrisch vermessen. Es konnte keine Verschlechterung des elektrischen Widerstands des ZnO festgestellt werden. Durch optische Messungen wurde nachgewiesen, dass die ursprünglich amorphe Silizium-Schutzschicht SS thermisch kristallisiert wurde. Die Schutzschicht SS erfüllt damit auch die Funktion einer einfach herzustellenden kristallinen Saatschicht.

Die verschiedenen Versuche zeigen, dass TCO-Schichten aus dotiertem ZnO, die durch amorphe oder polykristalline Schutzschichten SS aus Silizium geschützt sind, bei Temperaturen oberhalb 450°C prozessiert werden können. Es ist nahe liegend, dass auch Siliziumlegierungen wie SiₓO_{y}, SiₓGe_{y}, oder SiₓC_{y} den gewünschten Effekt zeigen, ebenso ist neben Silizium das Element Germanium Ge geeignet.

### EIGENSCHAFTEN DER ZNO:AL-SCHICHT OHNE TEMPERATURSTABILISIERUNGSSCHICHT

Um den Einfluss der Herstellungstemperatur (425°C bis 525°C) auf die Eigenschaften des ZnO:Al-Films zu erkennen, wurden die elektrischen und optischen Eigenschaften eines bloßen (unbehandelten) ZnO:AL-Films auf einem Glassubstrat vor und nach einer Wärmebehandlung (hier in N₂, möglich auch in normaler Umgebungsluft) untersucht. Dabei wurden zwei Erhitzungszeiten (4 und 16 h) durchlaufen, um eine Temperaturabhängigkeit erkennen zu können. Den Schichtwiderstand Rₛ [Ω/Fläche] des ZnO:Al-Films auf Glas in Abhängigkeit von der Temperatur T_{A} (Annealing temperature [°C]) zeigt die **FIGUR 2A** (Quadrate: 4h, Kreise: 16h). Zum Vergleich wurde der Schichtwiderstand Rₛ von ZnO ohne Wärmebehandlung eingezeichnet (6,3 Ω, gestrichelte Linie). Der Schichtwiderstand Rₛ der Proben bei einer Temperatur T_{A} von 425°C beträgt nach 4h bzw. 16h 48,5 bzw. 91,2 Ω/Fläche. Eine Temperaturabhängigkeit konnte bis zu einer Temperatur T_{A} von 450°C nicht erkannt werden. Oberhalb von einer Temperatur T_{A} von 450°C steigt der Schichtwiderstand Rₛ der ZnO:Al-Schicht jedoch signifikant mit steigender Herstellungstemperatur an. Die Gründe für den starken Anstieg des Schichtwiderstands Rₛ sind in einer auftretenden Verringerung der freien Ladungsträgerdichte und der Mobilität der Ladungsträger bei diesen hohen Temperaturen zu sehen.

Die **FIGUR 2B** zeigt die optische Transparenz der ZnO:Al-Schicht unter den zuvor beschriebenen Bedingungen. Die Transparenz der ZnO:Al-Schicht zeigt im UV- (ultraviolett) und im VIS- (sichtbar) Bereich keine Veränderungen während der Temperung. Jedoch steigt die Transparenz im NIR- (nahes Infrarot) Bereich nach der Temperung stark an.

### BESCHREIBUNG DER ERGEBNISSE

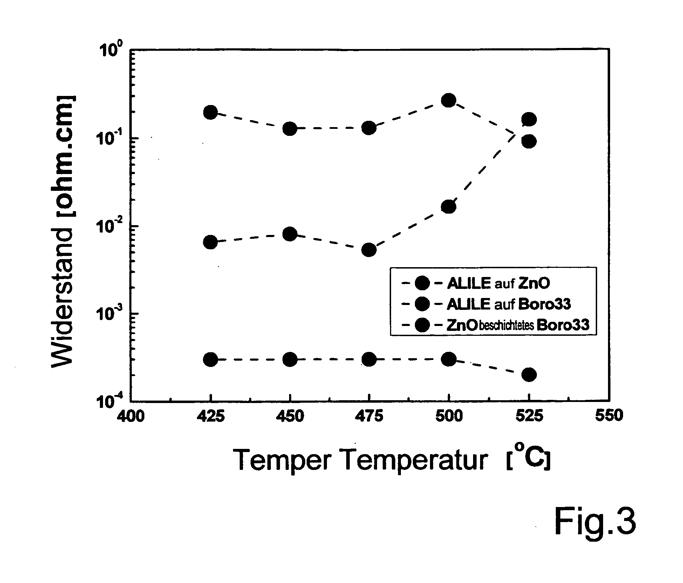

An den Glassubstrat/ZnO:Al/poly-Si-Strukturen wurde der spezifische Widerstand [ohm·cm] des ZnO:Al/poly-Si-Schichtpakets als Funktion der Temperatur T_{A} gemessen. Zum Vergleich wurden auch die spezifischen Widerstände von poly-Si-Schichten (ohne ZnO:Al) und ZnO:Al-Schichten (ohne poly-Si) gemessen. Die **FIGUR 3** zeigt die Ergebnisse in Abhängigkeit der Temperatur T_{A}. Der spezifische Widerstand der poly-Si-Schicht liegt im Bereich von ca. 10⁻¹ Ω·cm **(****FIGUR 3** oberer Graph). Eine systematische Abhängigkeit von der Temperatur T_{A} ist nicht erkennbar. Der spezifische Widerstand der der ZnO:Al-Schicht liegt oberhalb von ca. 5x10⁻³ Ω·cm **(****FIGUR 3** mittlerer Graph). Gegenüber dem spezifischen Widerstand vor der Wärmebehandlung (3x10⁻⁴ Ω·cm) hat sich also der spezifische Widerstand stark vergrößert. Oberhalb von T_{A} = 475°C ist ein weiterer starker Anstieg des spezifischen Widerstandes zu beobachten. Im Gegensatz zur Glassubstrat/ZnO:Al-Struktur weist die Glassubstrat/ ZnO:Al/ poly-Si-Struktur einen spezifischen Widerstand auf, der ungefähr dem spezifischen Widerstand der ZnO:Al-Schicht vor der Temperaturbehandlung (3 x 10⁻⁴ Ω·cm) entspricht bzw. sogar darunter liegt **(****FIGUR 3** unterer Graph). Dies bedeutet, dass sich der spezifische Widerstand der ZnO:Al-Schicht unterhalb der poly-Si-Schicht nicht geändert hat. Oberhalb von T_{A} = 500°C verringert sich der spezifische Widerstand sogar noch.

### SCHLUSSFOLGERUNG

Die beschriebenen Ergebnisse zeigen, dass durch die Schutzschicht SS auf der ZnO:Al-Schicht eine Vergrößerung des spezifischen Widerstands durch eine Prozessierung bei einer Temperatur T_{P} vermieden werden kann. Dies ermöglicht den Einsatz von ZnO:Al-Schichten auch in Schichtstrukturen bzw. Bauelementen, die höhere Prozesstemperaturen oberhalb einer Temperatur T_{P}, bei der bei einer ungeschützten TCO-Schicht aus dotiertem ZnO Veränderungen der optischen und elektrischen Eigenschaften eintreten würden, erfordern. Somit ergeben sich neue Anwendungsgebiete für die temperaturstabile ZnO:Al-Schicht nach der Erfindung.

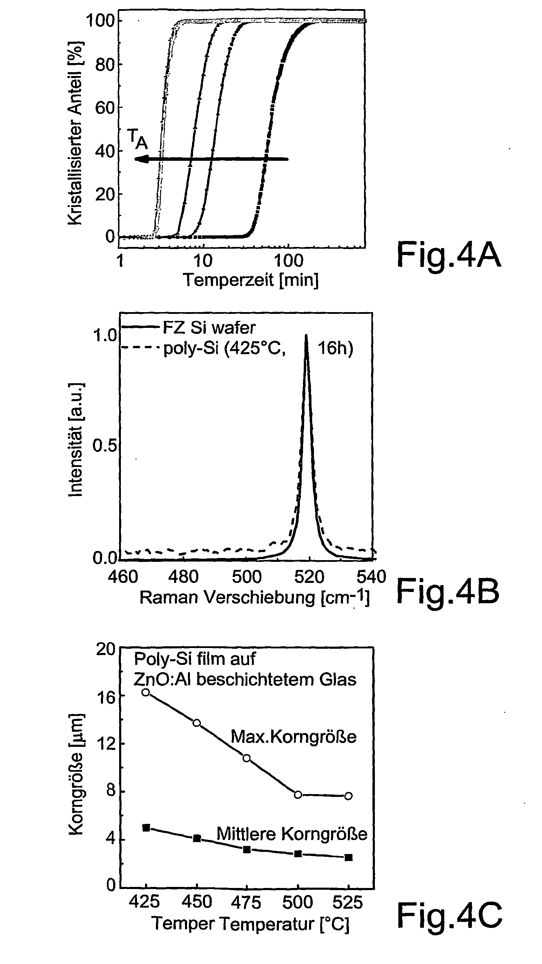

Die FIGUREN 4A bis C zeigen noch Diagramme zur Kristallqualität der Schutzschicht SS. Die Kristallqualität ist zu berücksichtigen, wenn die Schutzschicht SS nach der Erfindung als Keimschicht für eine zu prozessierende polykristalline Si-Dünnschicht-Solarzelle eingesetzt werden soll. Der dafür erforderliche Hochtemperaturprozess verändert allerdings nun nicht mehr die optischen und elektrischen Eigenschaften der temperaturstabilen ZnO:Al-Schicht, sodass diese bei derartigen Solarzellen eingesetzt werden kann und dabei zu einer Vereinfachung des Kontaktierungskonzepts führt.

Die **FIGUR 4A** zeigt den Kristallisierungsanteil während des Erwärmungsprozesses bei verschiedenen Temperaturen T_{A} (525, 500, 475, 450 und 425 °C). Die **FIGUR 4B** zeigt das normalisierte Ramanspektrum der Schutzschicht SS auf dem ZnO:Al-beschichteten Glas nach einer Wärmebehandlung bei T_{A} = 425°C für 16 h (gestrichelte Linie). Das Spektrum entspricht dem normalen Spektrum einer solchen schicht (durchgezogene Linie). Die **FIGUR 4C** zeigt die Korngrößenverteilung (Kreise: maximale Korngröße, Quadrate: gemittelte Korngröße) in der Schutzschicht SS als Funktion der Temperatur T_{A}. Zu erkennen ist eine Verringerung der Korngrößen in Richtung auf T_{A} = 450°C, weshalb zur Erzielung möglichst großer Korngrößen die Temperaturen T_{A} = 450°C nicht übersteigen sollten. Weiterhin zeigen die gebildeten Kristallite eine Vorzugsrichtung (001). Ein großer Anteil (mehr als 60%) der Kristallite weichen in ihrer Ausrichtung nicht mehr als 20° von der perfekten 100-Orientierung ab. Dies ändert sich auch nicht bei einer ansteigenden Temperatur T_{A}.

### BEZUGSZEICHENLISTE

- Al: Aluminiumschicht
- a-Si: amorphe Siliziumschicht
- Al(+Si island): Aluminiumschicht mit Silizium-Inseln
- ME: Membran
- SS: Schutzschicht
- SU: Substrat
- T_{A}: Temperatur zur Erzeugung von SS
- TCO: transparente und leitfähige Oxidschicht
- T_{P}: Temperatur, oberhalb der bei einer ungeschützten TCO-Schicht aus dotiertem ZnO Veränderungen der optischen und elektrischen Eigenschaften eintreten würden
- ZnO: Zinkoxid
- ZnO:Al: mit Aluminium dotiertes Zinkoxid

## Patentansprüche

1. Transparente und leitfähige Oxidschicht (TCO-Schicht) aus Aluminium-dotiertem Zinkoxid (ZnO:Al) auf einem Substrat (SU), herstellbar in einer Dicke von 690 nm durch nicht-reaktives RF-Sputtern mit einem ZnO:Al₂O₃-Target mit 1 Gew% Al₂O₃ bei einem Druck von 0,1 Pa während der Deposition und einer Substrattemperatur von 300°C, mit einer transparenten und leitfähigen anorganischen Schutzschicht (SS) aus Silizium auf der substratabgewandten Oberfläche, herstellbar durch anschließendes Erhitzen bei einer Temperatur T_{A} zwischen 425°C und 525°C, wobei bei einer bis 500°C erzeugten Schutzschicht (SS) der spezifische Widerstand der ZnO:Al-Schicht konstant bei 3·10⁻⁴ Ω·cm und bei einer ab 500°C erzeugten Schutzschicht (SS) unterhalb von 3·10⁻⁴ Ω·cm liegt.

2. TCO-Schicht nach Anspruch 1,
**GEKENNZEICHNET DURCH**
ein Substrat (SU) aus Glas.

3. TCO-Schicht nach Anspruch 1,
**GEKENNZEICHNET DURCH**
eine Schichtdicke der Schutzschicht (SS) in einem Bereich von 100 nm.

4. TCO-Schicht nach Anspruch 1,
**GEKENNZEICHNET DURCH**
eine Schichtdicke der Schutzschicht (SS) für eine Anwendung als hochdotierte kristallisierte Saatschicht in einem Bereich von 10 nm bis 20 nm.

5. Verfahren zur Herstellung einer transparenten und leitfähigen Oxidschicht (TCO-Schicht) aus Aluminium-dotiertem Zinkoxid (ZnO:Al) in einer Dicke von 690 nm auf einem Substrat (SU) mit einer transparenten und leitfähigen, anorganischen Schutzschicht (SS) aus Silizium auf der substratabgewandten Oberfläche nach einem der Ansprüche 1 bis 4 durch nicht-reaktives RF-Sputtern mit einem ZnO:Al₂O₃-Target mit 1 Gew% Al₂O₃ bei einer Substrattemperatur von 300°C und anschließendes Erhitzen bei einem Druck von 0,1 Pa während der Deposition und einer Temperatur T_{A} zwischen 425°C und 525°C.

## Claims

1. A transparent conductive oxide layer (TCO layer) made of aluminium-doped zinc oxide (ZnO:Al) on a substrate (SU), said oxide layer being producible in a thickness of 690 nm by non-reactive RF sputtering with a ZnO:Al₂O₃ target containing 1 % by weight Al₂O₃ at a pressure of 0.1 Pa during deposition and at a substrate temperature of 300 °C, comprising a transparent and conductive inorganic protective layer (SS) made of silicon on the surface facing away from the substrate, said protective layer being producible by subsequent heating at a temperature T_{A} between 425 °C and 525 °C, wherein, in the case of a protective layer (SS) produced at up to 500 °C, the specific resistance of the ZnO:Al layer lies constantly at 3·10⁻⁴ Ω·cm and, in the case of a protective layer (SS) produced from 500 °C, lies below 3·10⁻⁴ Ω·cm.

2. The TCO layer according to claim 1, **characterised by** a substrate (SU) made of glass.

3. The TCO layer according to claim 1, **characterised by** a layer thickness of the protective layer (SS) in the region of 100 nm.

4. The TCO layer according to claim 1, **characterised by** a layer thickness of the protective layer (SS) in a range of 10 nm to 20 nm for an application as a highly doped, crystallised seed layer.

5. A method for producing a transparent and conductive oxide layer (TCO layer) made of aluminium-doped zinc oxide (ZnO:Al) in a thickness of 690 nm on a substrate (SU), comprising a transparent and conductive, inorganic protective layer (SS) made of silicon on the surface facing away from the substrate according to any one of claims 1 to 4 by non-reactive RF sputtering with a ZnO:Al₂O₃ target containing 1 % by weight Al₂O₃ at a substrate temperature of 300 °C and subsequent heating at a pressure of 0.1 Pa during deposition and at a temperature T_{A} between 425 °C and 525 °C.

## Revendications

1. Couche d'oxyde transparente et conductrice (couche TCO) en oxyde de zinc dopé à l'aluminium (ZnO:Al) sur un substrat (SU), susceptible d'être préparée dans une épaisseur de 690 nm en procédant à une pulvérisation cathodique RF non-réactive en mettant en oeuvre une cible ZnO:Al₂O₃ avec 1 % en poids d'Al₂O₃, la pression étant de 0,1 Pa pendant le dépôt et la température dudit substrat étant de 300 °C, pourvue d'une couche protectrice (SS) inorganique en silicium de nature transparente et conductrice sur la surface située à l'opposé dudit substrat, susceptible d'être préparée en procédant ensuite à un réchauffement à une température T_{A} entre 425 °C et 525 °C, la résistivité de ladite couche ZnO:Al étant systématiquement de 3·10⁻⁴ Ω·cm lorsque la couche protectrice (SS) est réalisée à moins de 500 °C, alors qu'elle est inférieure à 3·10⁻⁴ Ω·cm lorsque la couche protectrice (SS) est réalisée à 500 °C ou plus.

2. Couche TCO selon la revendication 1,
**CARACTÉRISÉE PAR**
un substrat (SU) en verre.

3. Couche TCO selon la revendication 1,
**CARACTÉRISÉE PAR**
une épaisseur de couche de la couche protectrice (SS) d'environ 100 nm.

4. Couche TCO selon la revendication 1,
**CARACTÉRISÉE PAR**
une épaisseur de couche de la couche protectrice (SS) qui, pour une application en tant que couche d'ensemencement cristallisée à haut degré de dopage, est comprise entre 10 nm et 20 nm.

5. Procédé de préparation d'une couche d'oxyde transparente et conductrice (couche TCO) en oxyde de zinc dopé à l'aluminium (ZnO:Al) dans une épaisseur de 690 nm sur un substrat (SU), avec une couche protectrice (SS) inorganique en silicium de nature transparente et conductrice sur la surface située à l'opposé dudit substrat selon l'une des revendications 1 à 4, en procédant à une pulvérisation cathodique RF non-réactive en mettant en oeuvre une cible ZnO:Al₂O₃ avec 1 % en poids d'Al₂O₃, la température dudit substrat étant de 300 °C, et ensuite à un réchauffement, la pression étant de 0,1 Pa pendant le dépôt et la température T_{A} se situant entre 425 °C et 525 °C.
